Europäisches Patentamt

European Patent Office

Office européen des brevets

(19)

(11) **EP 1 425 860 B1**

(12) **EUROPEAN PATENT SPECIFICATION**

(45) Date of publication and mention
of the grant of the patent:
**12.01.2005 Bulletin 2005/02**

(51) Int Cl.$^7$: **H03M 13/13**

(86) International application number:
**PCT/GB2002/004100**

(21) Application number: **02755350.2**

(22) Date of filing: **10.09.2002**

(87) International publication number:
**WO 2003/023976 (20.03.2003 Gazette 2003/12)**

(54) **APPARATUS AND METHODS FOR BLOCK ENCODING DATA**

VORRICHTUNG UND VERFAHREN ZUR BLOCKCODIERUNG VON DATEN

APPAREIL ET PROCEDES DE CODAGE DE DONNEES PAR BLOCS

(84) Designated Contracting States:
**AT BE BG CH CY CZ DE DK EE ES FI FR GR IE
IT LI LU MC NL PT SE SK TR**

(30) Priority: **12.09.2001 GB 0121943**

(43) Date of publication of application:
**09.06.2004 Bulletin 2004/24**

(73) Proprietor: **Ubinetics Limited
Melbourn, Hertfordshire SG8 6DP (GB)**

(72) Inventor: **LARKIN, Robert
Cambridge CB4 1JT (GB)**

(74) Representative: **Mackenzie, Andrew Bryan et al
Marks & Clerk
45 Grosvenor Road
St. Albans, Hertfordshire AL1 3AW (GB)**

(56) References cited:
**WO-A-01/03366**

• **"Universal Mobile Telecommunications System
(UMTS);Physical channels and mapping of
transport channels onto physical channels
(FDD) (3GPP TS 25.211 version 3.4.0 Release
1999)" ETSI TS 125 211 V3.4.0, XX, XX,
September 2000 (2000-09), page COMPLETE44
XP002185178**

**Description**

This invention relates to the block encoding of data and in particular, though not exclusively, to block encoding of a transport format combination indicator (TFCI) for a universal mobile telecommunications system (UMTS) cellular network.

UMTS is the European proposal for third generation (3G) cellular networks. The UMTS network is inter-operable with the existing GSM network and provides the potential for high speed packet-switched data transmission. The UMTS transmission protocols are defined in a series of 3GPP standards. The standards define a plurality of layers for transmissions (broadly in alignment with the ISO 7 layer definition) having a physical layer (commonly termed layer 1; L1), a data link layer (commonly termed layer 2; L2) and a network layer (layer 3; L3). At the physical layer, data is transmitted in frames of 10 millisecond duration each of which contains 15 slots. Each slot is logically assigned to a channel. The details of the frame structure and channel mappings are not the subject of this invention and thus the reader is referred to the appropriate ETSI standard (TS25.211, "Physical channels and mapping of transport channels on to physical channels (FDD)") for further background information.

At the physical layer, many logical channels (and therefore slots in a frame) carry control information such as pilot bits and power control bits. Optionally, also, the control information may include a transport format combination indicator (TFCI) which provides the receiver with information about the combination of transport formats which are contained within the slot which carried the TFCI. If data of differing rates is carried in the slots (which is permitted by UMTS) then the TFCI is used to allow the correct decoding to be applied in order to extract data from the slot and provide it to the medium access control layer (MAC) at layer 2 of the protocol. The TFCI is not transmitted in the case of blind transport format detection.

The TFCI is encoded before transmission using a (32,10) sub-code of a second order Reed-Muller code. If the indicator is of less than 10bits then it is padded by setting the most significant bits to 0. Following block encoding, the TFCI code word is 32bits long.

It will be appreciated that a 32,10 code requires 320bits of storage for the encoding matrix (32 x 10) and as explained in more detail below, requires relatively complex processing in order to encode the TFCI. In the context of user equipment (UE) such as a compact mobile telephone with silicon area restrictions, it will be appreciated that it is desirable to simplify the encoding of the TFCI as much as possible.

Document WO 01/03366 discloses an apparatus for TFCI encoding using a Reed-Muller code. It comprises means for ANDing the TFCI information bits with the output of a sequence generator.

In accordance with a first aspect of the invention there is provide a method of block encoding an unencoded word to produce a code word comprising providing a counter operable to count through a binary sequence having a bit-width of less than the total bit width of the unencoded word, providing a buffer having a bit-width at least equal to the bit-width of the code word, operating the counter through the range of the total number of bits in the code word, performing a logical AND operation between the counter value and a predetermined subset of the bits of the unencoded word for each value of the counter in the said range, performing a modulo 2 operation on the result of the logical AND operation, storing the result of the modulo 2 operation in a predetermined bit position in the buffer, the predetermined position having a predetermined relationship to the value of the counter, determining that the counter has counted through a sequence having a number of values at least equal to the bit width of the code word and outputting the content of the buffer as the code word.

In a second aspect, there is provided apparatus for block encoding an unencoded word to produce a code word comprising a counter, a buffer, and a logic processor operable to perform AND and modulo 2 operations, the counter being arranged to count through a binary sequence having a bit-width less than the total bit-width of the unencoded word, the logic processor being arranged to AND the counter value with a predetermined subset of bits from the unencoded word and to perform a modulo 2 operation on the result, the buffer being arranged to accept the result of the modulo 2 operation and to store the result in a bit position which bears a predetermined mapped relationship with the counter value, and the apparatus being arranged to provide the output code word from the buffer when the counter has counted through a sequence having a number of values at least equal to the bit width of the code word.

Embodiments of the invention will now be described by way of example with reference to the drawings in which:-

Figure 1 is a block diagram of a possible hardware implementation of the invention; and
Figure 2 is a flow diagram showing the steps to be carried out when operating the method of the present invention.

As described above, the TFCI is typically encoded using a (32,10) second order Reed-Muller code.. The techniques described above may also be applied to the other Reed-Muller scenarios and also to other block encoding schemes.

It will also be appreciated that although the encoding is generally carried out at a transmitter prior to transmitting a slot to a receiver, it is possible that a decoder will use the same technique in a receiver in order to provide a reference against which the receiver decoding algorithms operate.

The code words of the (32,10) sub-code of the second order Reed-Muller code which are used for the TFCI encoding are a linear combination of 10 basis sequences. The basis sequences are shown in Table 1 below.

| i | M(i,0) | M(i,1) | M(i,2) | M(i,3) | M(i,4) | M(i,5) | M(i,6) | M(i,7) | M(i,8) | M(i,9) |
|---|--------|--------|--------|--------|--------|--------|--------|--------|--------|--------|
| 0 | 1 | 0 | 0 | 0 | 0 | 1 | 0 | 0 | 0 | 0 |
| 1 | 0 | 1 | 0 | 0 | 0 | 1 | 1 | 0 | 0 | 0 |
| 2 | 1 | 1 | 0 | 0 | 0 | 1 | 0 | 0 | 0 | 1 |
| 3 | 0 | 0 | 1 | 0 | 0 | 1 | 1 | 0 | 1 | 1 |
| 4 | 1 | 0 | 1 | 0 | 0 | 1 | 0 | 0 | 0 | 1 |
| 5 | 0 | 1 | 1 | 0 | 0 | 1 | 0 | 0 | 1 | 0 |
| 6 | 1 | 1 | 1 | 0 | 0 | 1 | 0 | 1 | 0 | 0 |
| 7 | 0 | 0 | 0 | 1 | 0 | 1 | 0 | 1 | 1 | 0 |
| 8 | 1 | 0 | 0 | 1 | 0 | 1 | 1 | 1 | 1 | 0 |
| 9 | 0 | 1 | 0 | 1 | 0 | 1 | 1 | 0 | 1 | 1 |
| 10 | 1 | 1 | 0 | 1 | 0 | 1 | 0 | 0 | 1 | 1 |
| 11 | 0 | 0 | 1 | 1 | 0 | 1 | 0 | 1 | 1 | 0 |
| 12 | 1 | 0 | 1 | 1 | 0 | 1 | 0 | 1 | 0 | 1 |
| 13 | 0 | 1 | 1 | 1 | 0 | 1 | 1 | 0 | 0 | 1 |
| 14 | 1 | 1 | 1 | 1 | 0 | 1 | 1 | 1 | 1 | 1 |
| 15 | 1 | 0 | 0 | 0 | 1 | 1 | 1 | 1 | 0 | 0 |
| 16 | 0 | 1 | 0 | 0 | 1 | 1 | 1 | 1 | 0 | 1 |
| 17 | 1 | 1 | 0 | 0 | 1 | 1 | 1 | 0 | 1 | 0 |
| 18 | 0 | 0 | 1 | 0 | 1 | 1 | 0 | 1 | 1 | 1 |
| 19 | 1 | 0 | 1 | 0 | 1 | 1 | 0 | 1 | 0 | 1 |
| 20 | 0 | 1 | 1 | 0 | 1 | 1 | 0 | 0 | 1 | 1 |
| 21 | 1 | 1 | 1 | 0 | 1 | 1 | 0 | 1 | 1 | 1 |
| 22 | 0 | 0 | 0 | 1 | 1 | 1 | 0 | 1 | 0 | 0 |
| 23 | 1 | 0 | 0 | 1 | 1 | 1 | 1 | 1 | 0 | 1 |
| 24 | 0 | 1 | 0 | 1 | 1 | 1 | 1 | 0 | 1 | 0 |
| 25 | 1 | 1 | 0 | 1 | 1 | 1 | 1 | 0 | 0 | 1 |
| 26 | 0 | 0 | 1 | 1 | 1 | 1 | 0 | 0 | 1 | 0 |
| 27 | 1 | 0 | 1 | 1 | 1 | 1 | 1 | 1 | 0 | 0 |
| 28 | 0 | 1 | 1 | 1 | 1 | 1 | 1 | 1 | 1 | 0 |
| 29 | 1 | 1 | 1 | 1 | 1 | 1 | 1 | 1 | 1 | 1 |
| 30 | 0 | 0 | 0 | 0 | 0 | 1 | 0 | 0 | 0 | 0 |
| 31 | 0 | 0 | 0 | 0 | 1 | 1 | 1 | 0 | 0 | 0 |

The TFCI information bits, $a_0$, $a_1$ ... $a_9$ (which form an unsigned TFC index and are able to indicate any one of 1024 possible transport format combinations) is processed according to the following equation

$$b(i) = \sum_{n=0}^{9} a(n).M(i,n)\%2$$

where x % 2 is the value of x counting modulo-2.

to arrive at a 32 bit TFCI having bits $b_k$, k = 0, 1,2,..., 31.

In hardware terms, the 10bit TFC index is ANDed with each of the 32 rows of the table, the result of each AND operation is reduced to a 1bit value by applying a modulo 2 operation (typically by XORing the 10bits together) and each of the modulo 2 bits then represents a single bit of the 32bit block encoded TFCI.

Thus to encode the TFC index, it is necessary to store a 320 bit table and to perform 32 10bit AND and XOR operations.

The technique described below may be used to considerably simplify this processing for any indicator limited to the input range {0,..., 63}.

For certain applications of the above encoding (with the above range restrictions) the four MSBs of the TFC index (bits 6-9) will always be 0. Thus the right-most four columns of the coefficient table given above have no impact on the final codeword. Therefore in the present invention, the rightmost four columns of the table are ignored. Furthermore, it will be noted that the Reed-Muller coding scheme has bit 5 (in the column M(1,5)) always set to 1. Thus it is not necessary to store the value of this bit.

Thus within the above restrictions, it is only necessary to deal with the four leftmost columns in the table. This realisation alone assists in reducing the complexity of the encoding process. However, as explained below, the process may further be simplified.

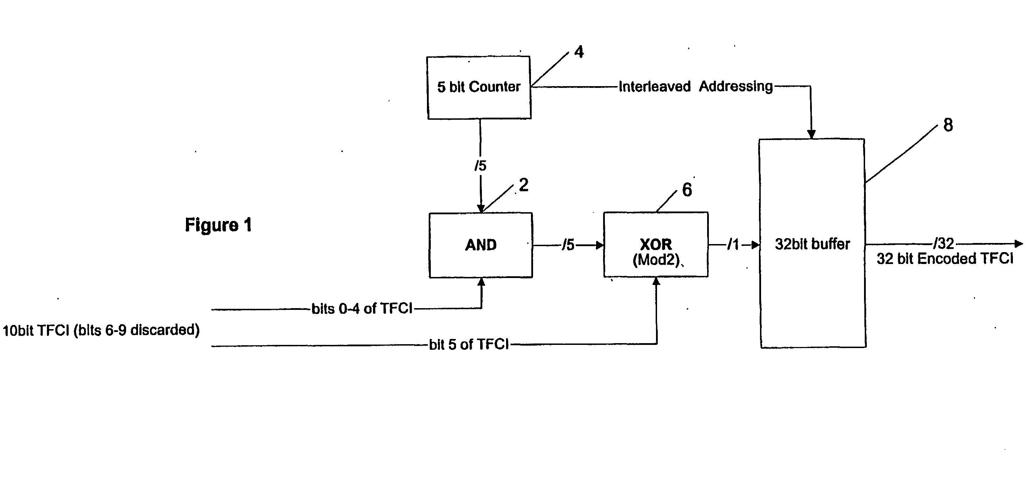

With reference to Figure 1 and for the reasons explained above, the topmost 4 bits of the TFC index (bits 6-9) may be discarded. The least significant five bits (0-4) may then be fed to the input of an AND logic circuit 2. A 5bit counter 4 may then be provided which in the example given below is arranged simply to count sequentially from 0 to 31. From the description below it will be appreciated that alternatively, the counter may count in a different sequence (which may, for example, be implemented using a state machine) in which case the address interleaving described below need not be applied.

It will be noted that one of the characteristics of the Reed-Muller basis sequences shown in the table is that each combination of bits in columns 0, 1, 2, 3 and 4 of the table is unique. Thus in decimal, each of the values 0-31 is uniquely represented by a separate row in the table. This means that if the counter 4 counts from 0-31 then each of the bit combinations represented in the rows of column 0-4 of the table will be produced.

However, from inspection of the table it will be noted that the values in the table do not count sequentially from 0-31. Instead, the correspondence is as shown in Table 2 below.

| Row in Table 1 (bit No. of TFCI) | Decimal value of corresponding bits in base sequences 0-4 |
|---|---|
| 0 | 1 |
| 1 | 2 |
| 2 | 3 |
| 3 | 4 |
| 4 | 5 |
| 5 | 6 |
| 6 | 7 |
| 7 | 8 |
| 8 | 9 |
| 9 | 10 |
| 10 | 11 |
| 11 | 12 |
| 12 | 13 |
| 13 | 14 |

(continued)

| Row in Table 1 (bit No. of TFCI) | Decimal value of corresponding bits in base sequences 0-4 |
|---|---|
| 14 | 15 |
| 15 | 17 |
| 16 | 18 |
| 17 | 19 |
| 18 | 20 |
| 19 | 21 |
| 20 | 22 |
| 21 | 23 |
| 22 | 24 |
| 23 | 25 |
| 24 | 26 |
| 25 | 27 |
| 26 | 28 |
| 27 | 29 |
| 28 | 30 |
| 29 | 31 |
| 30 | 0 |
| 31 | 16 |

Thus if the output of the AND circuit 2 is modulo 2 processed (for example, by XORing all the bits together using an XOR process 6) then the output of the XOR gate will represent one of the 32bits of the encoded TFCI. It will be noted that bit 5 of the TFC index is fed directly into the XOR process 6. This is because as noted above, bit 5 of the code table is always set and therefore bit 5 of the TFC index will always pass through the AND circuit 2 unchanged.

Referring to Table 2 above, if the counter 4 counts in the sequence 0-31 in order then the right hand number in the column provides the bit number into which the output bit from the XOR gate for that particular count must be put. Advantageously, a 32bit buffer 8 may be provided and the addressing of the buffer (in order to choose which bit position the output of the XOR gate 6 is placed) may be "interleaved" so that the mapping shown in Table 2 is applied between the output of the counter 4 and the bit position in the buffer 8 into which the output of the XOR gate is stored.

Alternatively, and as briefly mentioned above, if the counter counts in the sequence shown in the right hand column of Table 2 (for example, using a custom state machine) then the output of the XOR gate may simply be placed sequential into successive bit positions in the 32 bit buffer.

Whichever of the two implementations described above is taken, it will be noted that the stored encoding matrix shown in Table 1 of the prior art, is replaced with a counter and demultiplexing combination which considerably simplifies the encoding process.

A VHSIC hardware description language (VHDL) definition of Figure 1 is provided below

```
-- Description: Example of reduced TFCI encoder
-- Copyright (c) - Ubinetics 2001

library IEEE;
use IEEE.std_logic_1164.all;
use IEEE.std_logic_signed.all;

entity tfci_encoder is

    port (TFC          :in  std_logic_vector(5 downto 0);
          TFCI         :out std_logic_vector(31 downto 0);
          END_FLAG     :out std_logic;
          CLK          :in  std_logic;
          RST_H        :in  std_logic;
          EN_H         :in  std_logic);

end tfci_encoder;


architecture RTL of fir_tdl_std is

signal res: std_logic_vector(31 downto 0);
signal sum: std_logic;
signal count: integer range 31 downto 0;

begin

-- Increment count on clock edge.
-- Write output at end of cycle.
inc_count: process(CLK, RST_H) begin

   if (CLK'event and CLK = '1') then
      if (RST_H = '1') then
         count <=  (others => '0');
      elsif count = 31 then
            TFCI <= res;
            END_FLAG  <= '1';
```

```
                    -- end of encoding!
             else
                count <= count + 1;
                END_FLAG  <= '0';
             end if;
          end if;

end process;

-- encode logic for TFCI encoder
encode_logic: process(tfc, count) begin

    sum  <= ( TFC(1) and count(1) )
          xor ( TFC(2) and count(2) )
          xor ( TFC(3) and count(3) )
          xor ( TFC(4) and count(4) )
          xor ( TFC(5) and count(5) )
          xor TFC(6);

end process;

-- Use a line decoder to write enable the correct bit
-- in the "res" register according to the interleaving pattern
store_res: process(CLK, RST_H) begin

    if (CLK'event and CLK = '1') then
       if (RST_H = '1') then
          res  <=  (others => '0');
       else
          case count is
             when 1   => res(0)  <= sum;
             when 2   => res(1)  <= sum;
             when 3   => res(2)  <= sum;
             when 4   => res(3)  <= sum;
             when 5   => res(4)  <= sum;
             when 6   => res(5)  <= sum;
             when 7   => res(6)  <= sum;
             when 8   => res(7)  <= sum;
             when 9   => res(8)  <= sum;
             when 10  => res(9)  <= sum;
             when 11  => res(10) <= sum;
             when 12  => res(11) <= sum;
             when 13  => res(12) <= sum;
             when 14  => res(13) <= sum;
             when 15   => res(14) <= sum;
             when 17  => res(15) <= sum;
             when 18  => res(16) <= sum;
             when 19  => res(17) <= sum;
             when 20  => res(18) <= sum;
             when 21  => res(19) <= sum;
             when 22  => res(20) <= sum;
             when 23  => res(21) <= sum;
             when 24  => res(22) <= sum;
             when 25  => res(23) <= sum;
             when 26  => res(24) <= sum;
             when 27  => res(25) <= sum;
             when 28  => res(26) <= sum;
             when 29  => res(27) <= sum;
             when 30  => res(28) <= sum;
             when 31  => res(29) <= sum;
             when 0   => res(30) <= sum;
             when 16  => res(31) <= sum;
          end case;
       end if;
    end if;
```

```
end process;

end RTL;
```

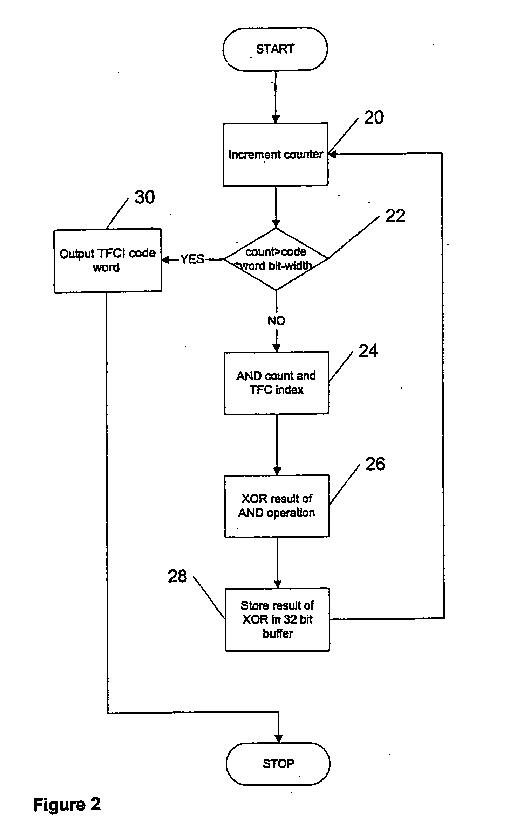

With reference to Figure 2, the processes involved are as follows. In step 20, the counter 2 is incremented. In step 22, the counter is checked to whether the encoding process has finished because the counter has counted through all possible combinations of the Reed-Muller codes (32 in the example given above).

The counter value is then ANDed with the least significant 5bits of the TFC index in step 24. In step 26, the result of the AND operation is XORed to produce a single bit value. The result of the XOR operation is then stored in the appropriate position in the 32bit buffer (step 28) and the operation repeated. When the process is complete, the TFCI is output from the buffer (step 30).

## Claims

1. A method of block encoding an unencoded word to produce a code word comprising:-

   (a) providing a counter (4) operable to count through a binary sequence having a bit-width of less than the total bit width of the unencoded word,
   (b) providing a buffer (18) having a bit-width at least equal to the bit-width of the code word,
   (c) operating the counter through the range of the total number of bits in the code word,
   (d) performing a logical AND operation (2) between the counter value and a predetermined subset of the bits of the unencoded word for each value of the counter in the said range,
   (e) performing a modulo 2 operation (6) on the result of the logical AND operation,
   (f) storing the result of the modulo 2 operation in a predetermined bit position in the buffer, the predetermined position having a predetermined relationship to the value of the counter,
   (g) determining that the counter has counted through a sequence having a number of values at least equal to the bit width of the code word and outputting the content of the buffer as the code word.

2. A method according to claim 1, wherein the first word is a Transport Format Combination Indicator (TFCI), the block encoding implements a Reed-Muller code and the code word is a TFCI code word for use in a UMTS frame.

3. A method according to claim 1 or claim 2, wherein the modulo 2 operation is carried out on a combination of the result of the logical AND operation and bits from the unencoded word which are not in the said subset of bits.

4. A method according to any preceding claim, wherein the bit-width of the unencoded word is 10 and wherein the bit-width of the code word is 32.

5. A method according to claim 4, wherein the code word is a TFCI code word for use with a 384kbps capability class UMTS transmission, and wherein the counter is operable to count through a predetermined 5bit binary sequence.

6. Apparatus for block encoding an unencoded word to produce a code word comprising:-

   (a) a counter,
   (b) a buffer, and
   (c) a logic processor operable to perform AND and modulo 2 operations,

   the counter being arranged to count through a binary sequence having a bit-width less than the total bit-width of the unencoded word, the logic processor being arranged to AND the counter value with a predetermined subset of bits from the unencoded word and to perform a modulo 2 operation on the result, the buffer being arranged to accept the result of the modulo 2 operation and to store the result in a bit position which bears a predetermined mapped relationship with the counter value, and the apparatus being arranged to provide the output code word from the buffer when the counter has counted through a sequence having a number of values at least equal to the bit width of the code word.

7. Apparatus according to claim 6, wherein the counter is a 5 bit counter and the buffer is a 32 bit buffer, the predetermined mapping between the bit positions in the buffer and the counter value being arranged to provide a Reed-Muller encoding for a TFCI for use in a UMTS network.

8. Apparatus according to claim 7, wherein the TFCI is for use in 384kbps capability class transmissions.

**Patentansprüche**

1. Verfahren zur Blockcodierung eines nichtcodierten Wortes, um ein Codewort zu erzeugen, mit den folgenden Schritten:

   (a) Bereitstellen eines Zählers (4), der betriebsfähig ist, eine Binärsequenz mit einer Bitbreite von weniger als der Gesamtbitbreite des nichtcodierten Wortes durchzuzählen,
   (b) Bereitstellen eines Puffers (8) mit einer Bitbreite, die mindestens gleich der Bitbreite des Codewortes ist,
   (c) Bewirken, daß der Zähler den Bereich der Gesamtanzahl von Bits im Codewort durchzählt,
   (d) Durchführen einer logischen UND-Operation (2) zwischen dem Zählerwert und einer vorbestimmten Teilmenge der Bits des nichtcodierten Wortes für jeden Wert des Zählers in diesem Bereich,
   (e) Durchführen einer Modulo-2-Operation (6) mit dem Ergebnis der logischen UND-Operation,
   (f) Speichern des Ergebnisses der Modulo-2-Operation in einer vorbestimmten Bitposition im Puffer, wobei die vorbestimmte Position eine vorbestimmte Beziehung zu dem Wert des Zählers hat,
   (g) Bestimmen, daß der Zähler eine Sequenz mit einer Anzahl von Werten durchgezählt hat, die mindestens gleich der Bitbreite des Codewortes ist, und Ausgeben des Inhalts des Puffers als das Codewort.

2. Verfahren nach Anspruch 1, wobei das erste Wort eine Transportformatkombinationskennzeichnung (TFCI) ist, die Blockcodierung einen Reed-Muller-Code implementiert und das Codewort ein TFCI-Codewort zur Verwendung in einem UMTS-Rahmen ist.

3. Verfahren nach Anspruch 1 oder 2, wobei die Modulo-2-Operation mit einer Kombination aus dem Ergebnis der logischen UND-Operation und Bits aus dem nichtcodierten Wort, die nicht in der Teilmenge von Bits sind, durchgeführt wird.

4. Verfahren nach einem der vorhergehenden Ansprüche, wobei die Bitbreite des nichtcodierten Wortes 10 ist und wobei die Bitbreite des Codewortes 32 ist.

5. Verfahren nach Anspruch 4, wobei das Codewort ein TFCI-Codewort zur Verwendung mit einer UMTS-Übertragung der 384-Kbit/s-Leistungsklasse ist und wobei der Zähler betriebsfähig ist, eine vorbestimmte 5-Bit-Binärsequenz durchzuzählen.

6. Vorrichtung zur Blockcodierung eines nichtcodierten Wortes, um ein Codewort zu erzeugen, mit:

   (a) einem Zähler
   (b) einem Puffer und
   (c) einem Logik-Prozessor, der betriebsfähig ist, UND- und Modulo-2-Operationen durchzuführen, wobei der Zähler geeignet ist, eine Binärsequenz mit einer Bitbreite durchzuzählen, die kleiner ist als die Gesamtbitbreite des nichtcodierten Wortes, wobei der Logik-Prozessor geeignet ist, den Zählerwert und eine vorbestimmte Teilmenge von Bits von dem nichtcodierten Wort einer UND-Operation zu unterziehen und mit dem Ergebnis eine Modulo-2-Operation durchzuführen, wobei der Puffer geeignet ist, das Ergebnis der Modulo-2-Operation anzunehmen und das Ergebnis in einer Bitposition zu speichern, die eine vorbestimmte zugeordnete Beziehung zu dem Zählerwert hat, und die Vorrichtung geeignet ist, ein Ausgabecodewort von dem Puffer bereitzustellen, wenn der Zähler eine Sequenz mit einer Anzahl von Werten durchgezählt hat, die mindestens gleich der Bitbreite des Codeworts ist.

7. Vorrichtung nach Anspruch 6, wobei der Zähler ein 5-Bit-Zähler ist und der Puffer ein 32-Bit-Puffer ist, wobei die vorbestimmte Zuordnung zwischen den Bitpositionen im Puffer und dem Zählerwert geeignet ist, eine Reed-Muller-Codierung für eine TFCI zur Verwendung in einem UMTS-Netzwerk bereitzustellen.

8. Vorrichtung nach Anspruch 7, wobei die TFCI zur Verwendung in Übertragungen der 384-Kbit/s-Leistungsklasse dient.

**Revendications**

1.  Procédé de codage par bloc d'un mot non codé pour produire un mot de code, comprenant:

    (a) la fourniture d'un compteur (4) qui peut fonctionner pour effectuer un comptage sur une séquence binaire présentant une largeur de bit inférieure à la largeur de bit totale du mot non codé;

    (b) la fourniture d'un tampon (8) qui présente une largeur de bit au moins égale à la largeur de bit du mot de code;

    (c) le fonctionnement du compteur sur la plage du nombre total de bits dans le mot de code;

    (d) la réalisation d'une opération ET logique (2) entre la valeur de compteur et un sous-jeu prédéterminé des bits du mot non codé pour chaque valeur du compteur dans ladite plage;

    (e) la réalisation d'une opération modulo 2 (6) sur le résultat de l'opération ET logique;

    (f) le stockage du résultat de l'opération modulo 2 en une position de bit prédéterminée dans le tampon, la position prédéterminée présentant une relation prédéterminée vis-à-vis de la valeur du compteur; et

    (g) la détermination du fait que le compteur a réalisé un comptage sur une séquence présentant un nombre de valeurs au moins égal à la largeur de bit du mot de code et l'émission en sortie du contenu du tampon en tant que mot de code.

2.  Procédé selon la revendication 1, dans lequel le premier mot est un indicateur de combinaison de format de transport (TFCI), le codage par bloc met en oeuvre un code de Reed-Muller et le mot de code est un mot de code TFCI pour une utilisation dans une trame UMTS.

3.  Procédé selon la revendication 1 ou 2, dans lequel l'opération modulo 2 est mise en oeuvre sur une combinaison du résultat de l'opération ET logique et de bits en provenance du mot non codé qui ne sont pas dans ledit sous-jeu de bits.

4.  Procédé selon l'une quelconque des revendications précédentes, dans lequel la largeur de bit du mot non codé est de 10 et dans lequel la largeur de bit du mot de code est de 32.

5.  Procédé selon la revendication 4, dans lequel le mot de code est un mot de code TFCI pour une utilisation avec une transmission UMTS de classe de capacité 384 kbps et dans lequel le compteur peut fonctionner pour réaliser un comptage sur une séquence binaire de 5 bits prédéterminée.

6.  Appareil pour un codage par bloc d'un mot non codé pour produire un mot de code, comprenant:

    (a) un compteur;

    (b) un tampon; et

    (c) un processeur logique pouvant fonctionner pour réaliser des opérations ET et modulo 2, le compteur étant agencé pour réaliser un comptage sur une séquence binaire présentant une largeur de bit inférieure à la largeur de bit totale du mot non codé, le processeur logique étant agencé pour soumettre à une logique ET la valeur de compteur avec un sous-jeu prédéterminé de bits en provenance du mot non codé et pour réaliser une opération modulo 2 sur le résultat, le tampon étant agencé pour accepter le résultat de l'opération modulo 2 et pour stocker le résultat en une position binaire qui est porteuse d'une relation cartographiée prédéterminée avec la valeur de compteur et l'appareil étant agencé pour fournir le mot de code de sortie depuis le tampon lorsque le compteur a réalisé un comptage sur une séquence présentant un nombre de valeurs au moins égal à la largeur de bit du mot de code.

7.  Appareil selon la revendication 6, dans lequel le compteur est un compteur de 5 bits et le tampon est un tampon de 32 bits, la cartographie prédéterminée entre les positions binaires dans le tampon et la valeur de compteur étant agencée pour assurer un codage de Reed-Muller pour un TFCI pour une utilisation dans un réseau UMTS.

8. Appareil selon la revendication 7, dans lequel le TFCI est pour une utilisation au niveau de transmissions de classe de capacité 384 kbps.

**Figure 1**

5 bit Counter — 4

Interleaved Addressing

/5

AND — 2

/5 →

XOR (Mod2) — 6

/1 →

32bit buffer

8

/32 —
32 bit Encoded TFCI

bits 0-4 of TFCI

10bit TFCI (bits 6-9 discarded)

bit 5 of TFCI

EP 1 425 860 B1

**Figure 2**